(19) Europäisches Patentamt / European Patent Office / Office européen des brevets

(11) **EP 2 846 357 A1**

(12) **DEMANDE DE BREVET EUROPEEN**

(43) Date de publication:
**11.03.2015  Bulletin 2015/11**

(51) Int Cl.:
**H01L 27/146** (2006.01)

(21) Numéro de dépôt: **14183209.7**

(22) Date de dépôt: **02.09.2014**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **04.09.2013  FR 1358460**

(71) Demandeur: **Commissariat à l'Énergie Atomique et aux Énergies Alternatives 75015 Paris (FR)**

(72) Inventeurs:
• **Gidon, Pierre**
  **38130 ECHIROLLES (FR)**
• **Moussy, Norbert**
  **38190 SAINT AGNES (FR)**

(74) Mandataire: **Brevalex**
  **95, rue d'Amsterdam**
  **75378 Paris Cedex 8 (FR)**

(54) **Dispositif photodétecteur a regions de semi-conducteurs séparées par une barrière de potentiel**

(57)  Dispositif photodétecteur (102) comprenant :
- une couche de semi-conducteur (104) dopé selon un premier type de conductivité ;
- deux premières portions (106a, 106b) de semi-conducteur dopé selon un deuxième type de conductivité opposé au premier type de conductivité, distinctes et espacées l'une de l'autre, et disposées dans la couche de semi-conducteur l'une à côté de l'autre ;
- une deuxième portion (108) de semi-conducteur dopé selon le premier type de conductivité avec un niveau de dopage supérieur à celui de la couche de semi-conducteur et délimitant, avec la couche de semi-conducteur, les premières portions en formant des jonctions p-n, dans lequel une partie (110) de la couche de semi-conducteur sépare les premières portions tel que des zones de charge d'espace entre les premières portions forment une barrière de potentiel dont le niveau est inférieur au potentiel de la deuxième portion et de la couche de semi-conducteur.

FIG. 6

EP 2 846 357 A1

## Description

## DOMAINE TECHNIQUE ET ART ANTÉRIEUR

L'invention concerne le domaine des photodétecteurs utilisés notamment pour la réalisation de capteurs d'image de type CMOS, ainsi qu'un capteur d'image comprenant des dispositifs photodétecteurs selon l'invention.

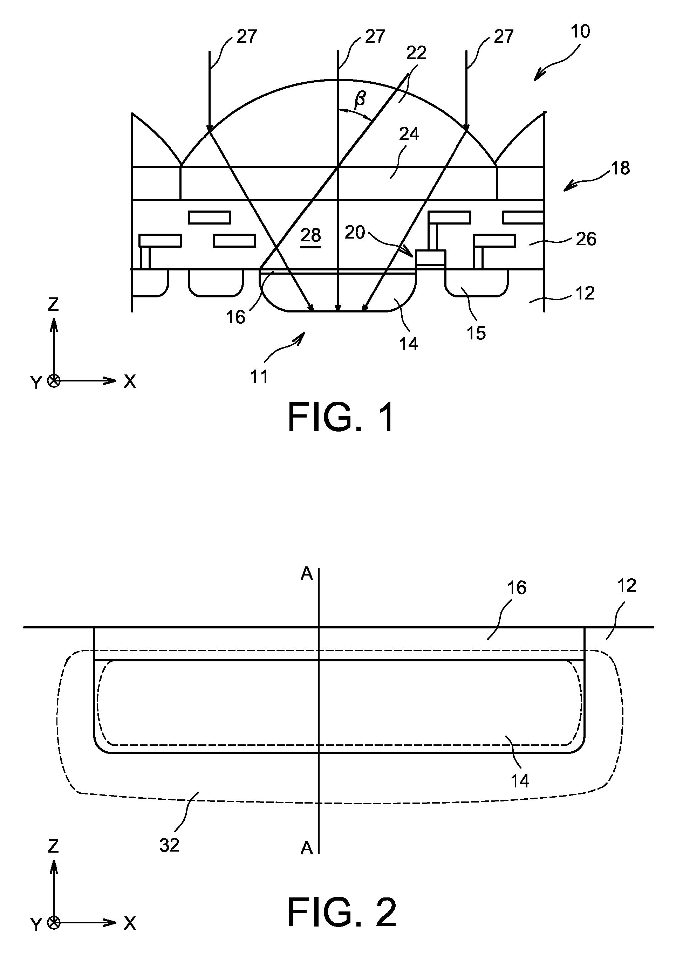

Un capteur d'image CMOS comporte une matrice de pixels, chaque pixel comprenant un dispositif photodétecteur. Un des pixels d'un capteur d'image CMOS 10 est représenté schématiquement en coupe sur la figure 1, les structures des autres pixels du capteur 10 étant similaires à celle du pixel représenté sur cette figure. Ce pixel comporte un dispositif photodétecteur 11 formé d'une zone photodétectrice réalisée dans une couche 12 de semi-conducteur, par exemple en silicium dopé p. Cette zone photodétectrice comporte une première région 14 dopée n de la couche 12, et une deuxième région 16 dopée p+ de la couche 12. Des niveaux d'interconnexions électriques 18 sont réalisés au-dessus de la couche 12. Ces niveaux d'interconnexions 18 comportent notamment des lignes électriques de connexion, des vias conducteurs reliant électriquement les différentes lignes électriques de connexion, ainsi que des grilles de transistors MOS du capteur 10. Ces niveaux d'interconnexions électriques sont formés dans des couches diélectriques transparentes 26, par exemple à base de $SiO_2$. Une grille de transfert 20 réalisée dans les niveaux d'interconnexions 18 est couplée à la zone photodétectrice (chaque pixel comporte également d'autres transistors non représentés sur la figure 1). Cette grille de transfert 20 permet de transférer les charges photo-générées, séparées par la jonction p-n et stockées dans la région 14, vers une autre région 15 dopée n de la couche 12. Différents circuits de lecture sont possibles. Ces circuits sont généralement désignés par le nombre de transistors nécessaires pour la lecture d'une zone de photodétection. On parle par exemple d'un circuit de lecture 3T ou 4T pour un circuit de lecture à 3 ou 4 transistors. Pour réaliser la lecture de plusieurs zones photodétectrices, il est possible de mutualiser certains des transistors entre les différents circuits de lecture, grâce à une lecture séquentielle des zones photodétectrices. Par exemple, pour 4 pixels fonctionnant avec des circuits de lecture 4T, il est possible de ne faire appel qu'à 6 transistors pour réaliser ces 4 circuits de lecture, soit 1,5 transistor par pixel.

Le dispositif photodétecteur 11 comporte également une optique disposée en regard de la zone photodétectrice. Cette optique comprend une microlentille 22 apte à focaliser des rayons lumineux 27 reçus par le pixel sur la zone photodétectrice du pixel, et un filtre coloré 24 faisant partie d'une matrice de Bayer. Une région 28 de ces couches diélectriques transparentes 26 se trouvant en regard de la zone photodétectrice, entre la zone photodétectrice et le filtre coloré 24, ne comporte pas d'interconnexions électriques afin que les rayons lumineux issus de cette optique puissent arriver dans la zone photodétectrice du pixel sans réflexion sur les niveaux d'interconnexions électriques. Le capteur d'image 10 est de type « front-side », c'est-à-dire comporte les niveaux d'interconnexions 18 disposés entre les zones photodétectrices des pixels et les optiques par lesquelles entre la lumière.

Chacune des zones photodétectrices du capteur 10 forme une capacité de stockage électrique. Les charges électriques photo-générées sont stockées dans cette capacité durant le temps d'intégration de l'image, correspondant au temps de pose du capteur 10. Le nombre de charges électriques pouvant être stockées dans la zone photodétectrice est limité par différentes contraintes physiques et notamment par la taille de la zone photodétectrice. Une fois le temps d'intégration terminé, les grilles de transfert 20 sont actionnées et les signaux délivrés par les zones photodétectrices correspondant aux charges électriques stockées sont alors transférées dans une capacité plus petite, amplifiant ainsi la tension vue qui est alors multiplexée dans une chaine de lecture permettant d'extraire l'information correspondant à l'image capturée. Une nouvelle image peut alors être capturée par le capteur 10.

Les régions 14 et 16 de la zone photodétectrice ainsi que le semi-conducteur de la couche 12 se trouvant autour de la région 14 forment ensemble des jonctions métallurgiques, ou jonctions p-n, où les photons absorbés génèrent des charges positives et négatives. Ces charges sont séparées par le champ électrique de la jonction p-n et intégrées dans la photodiode formée par la zone photodétectrice, puis lues par le système de lecture.

Les zones photodétectrices du capteur 10 ont des limites assez floues ou progressives, liées aux phénomènes de diffusion des porteurs et aux différents potentiels présents dans la structure. La zone de stockage de charges de la zone photodétectrice du dispositif photodétecteur 11 est par exemple représentée sur la figure 2. La première région 14 dopée n est entourée par un ensemble de jonctions p-n formées par l'interface entre les régions 14 et 16 et les interfaces entre la première région 14 et la couche 12. Ces jonctions forment une diode qui, si elle est polarisée en inverse, ne fait passer aucun courant. La tension de polarisation inverse reste si aucun autre phénomène ne déplace des charges. Il existe, au voisinage des jonctions p-n, une zone 32 dans laquelle le potentiel varie selon une pente continue allant du potentiel de la deuxième région 16 (qui est égal au potentiel dans le semi-conducteur dopé p de la couche 12) au potentiel de la première région 14, ou inversement. Cette zone 32, appelée zone de charge d'espace, est délimitée symboliquement par des pointillés sur la figure 2.

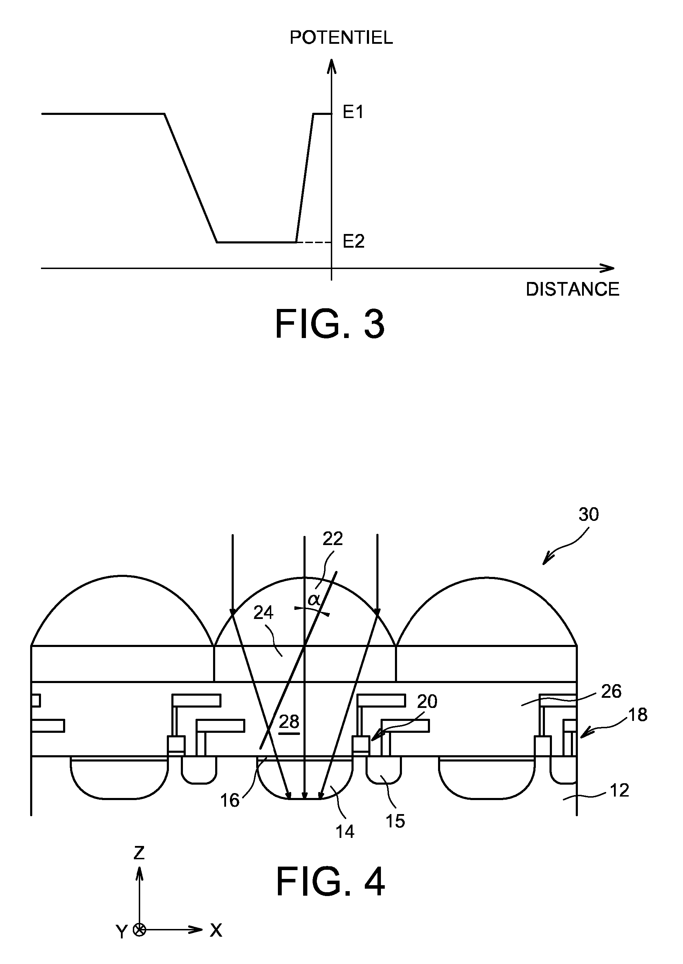

La figure 3 représente le potentiel obtenu au sein des différents éléments de la zone photodétectrice de la figure 2 le long de l'axe AA. Le profil de ce potentiel forme un puits pour les charges électriques entre une

première valeur $E_1$ correspondant au potentiel dans la deuxième région 16 et dans la couche 12, à une deuxième valeur $E_2$, inférieure à $E_1$ et correspondant au potentiel dans la première région 14. Les bords de ce puits sont schématisés par des pentes correspondant aux variations du potentiel dans la zone 32, et correspondant à des régions dans lesquelles s'établit un champ électrique. Ces pentes sont différentes selon la valeur absolue des dopages des semi-conducteurs où se trouve cette zone. Plus le dopage est fort (comme par exemple le dopage p+ de la deuxième région 16 par rapport au dopage p de la couche 12), plus la distance sur laquelle s'étant la variation de potentiel est faible. Le puits de potentiel a donc une dimension plus grande que la première région 14 dopée n, s'étend largement dans le semi-conducteur dopé p de la couche 12, très faiblement dans le semi-conducteur dopé p+ de la deuxième région 16 et son point le plus bas est à l'intérieur de la première région 14 dopée n.

Les charges positives et négatives photo-générées par la lumière reçue dans la zone photodétectrice ont une certaine durée de vie avant de se recombiner. Si elles sont générées dans la zone p (couche 102) à l'extérieur du puits de potentiel, elles vont diffuser dans le matériau, vers les zones où la densité de charges positives et négatives est la plus faible, par exemple jusqu'au bord du puits où elles sont séparées par le champ électrique, empêchant leur recombinaison. Si les charges sont générées dans le puits, qui est relativement étroit, les charges diffusent alors là aussi jusqu'au bord du puits. Avec les dopages indiqués ici, les charges de signe - (électrons) sont stockées dans le puits de potentiel, celles de l'autre signe + (trous) restent à l'extérieur du puits. Le puits de potentiel diminue au fur et à mesure de son remplissage par les électrons jusqu'à saturer et ne plus pouvoir stocker de charges additionnelles.

La profondeur maximale du puits dépend du niveau dopage des semi-conducteurs. La polarisation inverse ne peut pas enlever plus de charges qu'il y a d'atomes de dopant de type n dans cette configuration. Des dopages typiques sont les suivants : dopage p : quelques $10^{15}$ atomes/cm$^3$ ; dopage n : environ $10^{17}$ atomes/cm$^3$; dopage p+ : quelques $10^{18}$ atomes/cm$^3$.

Dans le domaine des capteurs d'image, afin d'améliorer la résolution des images capturées, on cherche à miniaturiser de plus en plus les pixels afin d'avoir le plus grand nombre de pixels pour une surface donnée du capteur. Cette miniaturisation des pixels s'accompagne toutefois de contraintes liées aux phénomènes physiques mis en jeu dans le capteur. En effet, la sensibilité d'un pixel dépend de son rapport signal sur bruit. Or, il existe un bruit, appelé bruit photonique, qui est la conséquence d'un phénomène statistique et dont la valeur dépend d'une fonction en racine du nombre de photons reçus.

Pour un même éclairement extérieur au capteur, un même temps de pose et une même optique, un pixel reçoit une quantité de photons proportionnelle à sa surface. Ainsi, plus la surface du pixel, et donc la surface de la zone photodétectrice, est petite (surface dans le plan (X,Y) représenté sur la figure 1, parallèle à un plan principal de la couche 12), plus le nombre de photons reçus et d'électrons stockés diminue. Une réduction de la surface du pixel réduit donc le rapport signal sur bruit photonique du capteur, la sensibilité du capteur devenant dans ce cas mauvaise.

De plus, en réduisant la taille des pixels, la zone de stockage des charges électriques devient plus petite pour un même champ électrique interne dans les jonctions des pixels. Cette zone de stockage de charges peut donc retenir moins de charges, ce qui limite la dynamique du capteur (en terme de luminosité, se traduisant, dans les images capturées, par des noirs dits « bouchés » et des blancs dits « grillés »).

De plus, en réduisant la surface des pixels, le coefficient d'absorption de la lumière par les filtres ou le semi-conducteur ne change pas. Le pixel a donc moins de surface dans le plan (X,Y) mais son épaisseur (dimension selon l'axe Z) diminue peu. Avec des épaisseurs d'optique et d'interconnexions électriques qui ne changent quasiment pas, des problèmes d'angle de vue optique apparaissent, le pixel ayant alors un cône d'acceptance des rayons lumineux plus étroit, ce qui a plusieurs conséquence néfastes sur les performances du système optique. La figure 4 représente schématiquement une vue en coupe d'une partie d'un capteur d'image 30 de structure analogue au capteur d'image 10, mais pour lequel les surfaces des pixels, dans le plan (X,Y), c'est-à-dire le plan sensiblement perpendiculaire à l'angle moyen des rayons lumineux reçus par le capteur d'image 30, ont été réduites. Cette réduction de la taille des pixels se traduit notamment par une réduction des dimensions, dans le plan (X,Y), des optiques (des microlentilles 22 et des filtres 24 dans cet exemple) et des zones photodétectrices (notamment des régions 14 et 16 dans cet exemple). L'angle d'acceptance $\alpha$ d'un pixel du capteur d'image 30 est plus petit que celui d'un pixel du capteur d'image 10 (angle d'acceptance $\beta$ sur la figure 1). Cela entraine également des phénomènes de vignettage de l'image capturée (assombrissement à la périphérie de l'image).

De plus, en réduisant les tailles des pixels, on observe une augmentation de la diffraction des ondes lumineuses dans le dispositif photodétecteur 11 du fait que les dimensions des éléments du dispositif sont du même ordre de grandeur que les longueurs d'ondes de la lumière capturée. Cette diffraction engendre des problèmes de diaphotie (« cross talk »).

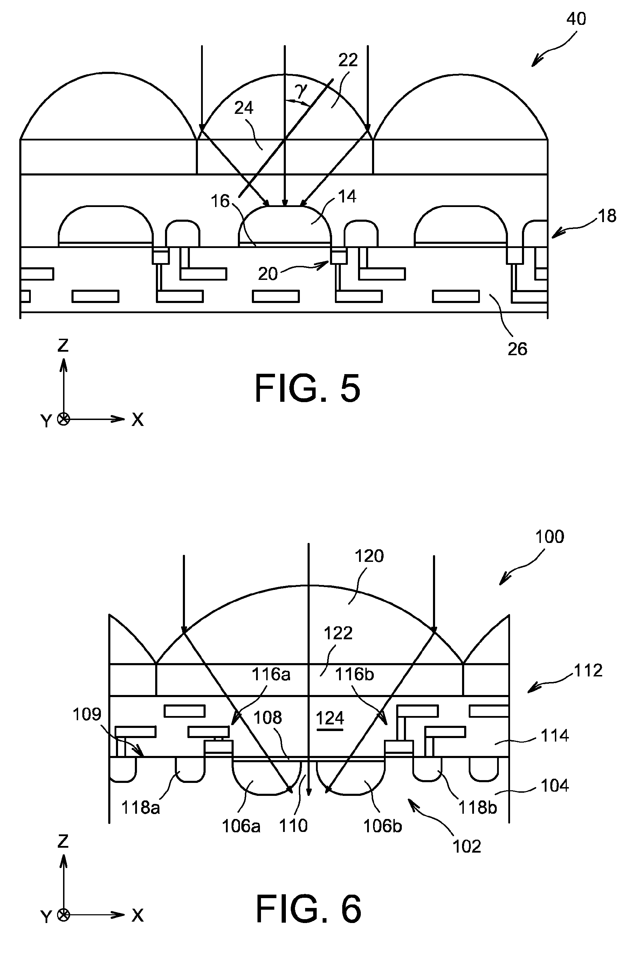

Pour résoudre les problèmes liés à l'angle d'acceptance étroit du capteur, il est possible de réaliser un capteur d'image 40 de type « back-side » tel que représenté schématiquement en coupe sur la figure 5. Dans un tel capteur d'image 40, les niveaux d'interconnexions 18 sont réalisés du côté d'une face de la couche de semi-conducteur 12 opposée à celle par laquelle entre la lumière.

Du fait que la lumière ne traverse pas les niveaux d'interconnexions 18, le système optique d'un tel pixel est donc moins directif que dans le cas du capteur d'image 30, en considérant des dimensions de pixels équivalentes, du fait que le cône d'acceptance des rayons lumineux est dans ce cas plus important (angle d'acceptance γ du capteur 40 supérieur à l'angle α du capteur 30). Toutefois, ce capteur d'image 40 « backside » est plus coûteux à réaliser qu'un capteur d'image de type « front-side » et ne permet pas de résoudre les problèmes de dynamique du capteur. Les problèmes de diaphotie peuvent être en partie résolus par la réalisation de barrières (tranchées) entre les pixels. Toutefois, cela implique également une augmentation du cout de réalisation du capteur.

Il est possible de compenser en partie les problèmes de rapport signal sur bruit photonique en changeant le système optique principal devant le capteur d'image (non représenté sur la précédentes figures 1 à 5) se trouvant loin devant les pixels, via l'utilisation d'une optique plus ouverte amenant plus de photons dans le capteur d'image ou bien en résolvant les problèmes de filtrage optique. Cela implique toutefois une augmentation sensible du coût du capteur.

## EXPOSÉ DE L'INVENTION

Un but de la présente invention est de proposer un dispositif photodétecteur pouvant notamment être utilisé au sein d'un capteur d'image, permettant de résoudre au moins en partie les problèmes posés par les capteurs d'image de l'art antérieur exposés précédemment, et permettant d'améliorer la qualité des images capturées sans avoir à miniaturiser les pixels ni augmenter le coût d'un capteur d'image comportant de tels dispositifs photodétecteurs.

Pour cela, la présente invention propose un dispositif photodétecteur comprenant au moins :

- une couche de semi-conducteur dopé selon un premier type de conductivité ;
- deux premières portions de semi-conducteur dopé selon un deuxième type de conductivité opposé au premier type de conductivité, distinctes et espacées l'une de l'autre, et disposées dans la couche de semi-conducteur l'une à côté de l'autre ;
- une deuxième portion de semi-conducteur dopé selon le premier type de conductivité avec un niveau de dopage supérieur à celui de la couche de semi-conducteur et délimitant, avec la couche de semi-conducteur, les premières portions telles que les premières portions forment, avec la couche de semi-conducteur et la deuxième portion, des jonctions p-n,

dans lequel au moins une partie de la couche de semi-conducteur dopé selon le premier type de conductivité sépare les premières portions de manière à ce que des zones de charge d'espace entre les premières portions forment au moins une barrière de potentiel dont le niveau est inférieur au niveau de potentiel de la deuxième portion et de la couche de semi-conducteur.

Ainsi, contrairement à la démarche classique d'amélioration de la qualité des images capturées via une réduction des dimensions des dispositifs photodétecteurs dans le but de pouvoir multiplier le nombre de pixels pour une surface donnée d'un capteur d'image, le dispositif photodétecteur selon l'invention comporte une architecture permettant d'obtenir, grâce aux « sous-zones » photodétectrices chacune formée par l'une des premières portions de semi-conducteur, la couche de semi-conducteur et la deuxième portion de semi-conducteur, plusieurs informations différentes à partir d'un seul pixel. Ces différentes informations correspondent notamment à la somme totale des charges électriques générées par l'ensemble des jonctions p-n du dispositif photodétecteur, ainsi que la manière dont sont réparties les charges photo-générées au sein des différentes sous-zones photodétectrices, c'est-à-dire la localisation des charges dans les différents puits de potentiel formés par les premières portions de semi-conducteur. Ces différentes informations permettent par exemple, par un ou plusieurs calculs réalisés à partir de ces informations, d'apporter des améliorations à l'image fournie par les pixels, via une exploitation numérique de ces informations obtenues à partir de chaque pixel. Il n'est donc plus nécessaire de miniaturiser autant les pixels, ce qui permet d'éviter l'ensemble des problèmes optiques liés à la miniaturisation des pixels.

Un tel dispositif photodétecteur comporte une zone de photodétection et de stockage de structure particulière dans laquelle les jonctions métallurgiques sont organisées différemment de celles des zones de photodétection des capteurs d'image de l'art antérieur. La zone photodétectrice est ici divisée en plusieurs sous-zones photodétectrices, chacune formée par l'une des premières portions de semi-conducteur qui, entourée par les autres portions de semi-conducteur et de la couche de semi-conducteur, forment une jonction p-n au niveau de la périphérie de ladite première portion de semi-conducteur. Chacune des premières portions de semi-conducteur forme un puits de potentiel, ces puits étant séparés entre eux par une barrière de potentiel électrique dont le niveau est inférieur au niveau de potentiel de la deuxième portion de semi-conducteur et de la couche de semi-conducteur. Ces sous-zones photodétectrices sont donc en contact électrique les unes avec les autres lors d'une capture d'images. Ainsi, quand une des sous-zones photodétectrices approche de la saturation de charges lors d'une capture d'image, ces charges passent la ou les barrières de potentiel qui sont les plus basses et vont dans la ou les sous-zones photodétectrices voisines. Ainsi, au sein d'un pixel, l'ensemble des sous-zones photodétectrices peuvent stocker au maximum quasiment autant de charges électriques que l'unique zone photodétectrice classique d'un pixel selon l'art antérieur, pour une même dimension de pixel. Une somme des signaux extraits depuis les différentes sous-zones photodétectrices du pixel permet donc d'obtenir un signal similaire à celui fourni par un pixel de l'art antérieur de dimensions équivalentes, correspondant à la somme des charges photo-générées dans le pixel.

Les charges photo-générées dans les différentes sous-zones photodétectrices du dispositif photodétecteur peuvent donc être lues par plusieurs dispositifs de lecture, ou noeuds de lecture, pouvant fonctionner indépendamment ou non les uns des autres, par exemple pilotés de manière synchrone.

L'information supplémentaire (relative à la ou aux différences de charges électriques générées dans les différentes sous-zones photodétectrices) obtenue avec un tel dispositif photodétecteur est bien une information d'intensité, mais ne correspond pas directement à l'intensité de l'image formée par une optique principale couplée au dispositif photodétecteur. Du fait du débordement possible des charges d'une zone à l'autre, c'est-à-dire de la circulation possible des charges entre les puits de potentiel formés par les premières portions de semi-conducteur, une dynamique, similaire à celle obtenue avec un pixel classique de même dimensions, entre le niveau du bruit et la saturation est obtenue.

Du fait que le niveau de dopage de la deuxième portion de semi-conducteur soit supérieur à celui de la couche de semi-conducteur, les zones de charges d'espace autour des premières portions de semi-conducteur ne s'étendent pas ou peu dans la deuxième portion de semi-conducteur, ce qui permet d'avoir dans cette deuxième portion de semi-conducteur un potentiel quasi constant servant alors de potentiel de référence vis-à-vis de la barrière de potentiel.

La deuxième portion de semi-conducteur peut être disposée dans la couche de semi-conducteur.

Le dispositif photodétecteur peut comporter en outre au moins autant de dispositifs de lecture distincts que de premières portions de semi-conducteur, chacun des dispositifs de lecture pouvant être couplé à une des premières portions de semi-conducteur et apte à réaliser un transfert de charges électriques stockées dans ladite une des premières portions de semi-conducteur vers une autre région de semi-conducteur.

Chaque dispositif de lecture peut comporter au moins une grille de transfert couplée à ladite une des premières portions de semi-conducteur.

Une largeur de la partie de la couche de semi-conducteur séparant les premières portions de semi-conducteur peut être telle que les zones de charges d'espace entre les premières portions de semi-conducteur se chevauchent.

Au moins une quatrième portion de semi-conducteur dopé selon le deuxième type de conductivité peut être disposée dans la partie de la couche de semi-conducteur entre les premières portions de semi-conducteur, un niveau de dopage des premières portions de semi-conducteur pouvant être supérieur à un niveau de dopage de la quatrième portion de semi-conducteur tel que le niveau de potentiel de la quatrième portion de semi-conducteur soit inférieur au niveau de potentiel de la deuxième portion et de la couche de semi-conducteur. Une telle configuration permet de réaliser une barrière de potentiel plus large, et donc techniquement plus facile à réaliser et/ou à reproduire à l'identique dans les pixels.

Dans ce cas, une largeur de la partie de la couche de semi-conducteur séparant les premières portions de semi-conducteur peut être telle que les zones de charges d'espace entre les premières portions ne se chevauchent pas. Cette absence de chevauchement des zones de charge d'espace ne pose pas de problème pour former la barrière de potentiel en raison de la quatrième portion de semi-conducteur présente entre les premières portions de semi-conducteur.

Dans un deuxième mode de réalisation, le dispositif photodétecteur peut comporter en outre au moins une grille de commande couplée à la partie de la couche de semi-conducteur et apte à commander une valeur du potentiel entre les premières portions de semi-conducteur. Dans ce cas, la circulation des charges électriques entre les premières portions de semi-conducteur peut se produire lorsqu'une tension suffisante est appliquée sur la grille de commande, formant ainsi un canal commandable entre les premières portions de semi-conducteur. On peut en outre définir précisément les niveaux de la ou des barrières de potentiel au sein du dispositif photodétecteur via la tension appliquée sur la grille de commande.

Le dispositif photodétecteur peut comporter plusieurs deuxièmes portions de semi-conducteur chacune délimitant, avec la couche de semi-conducteur, l'une des premières portions de semi-conducteur.

Le dispositif photodétecteur peut comporter une pluralité de premières portions de semi-conducteur disposées les unes à côté des autres dans la couche de semi-conducteur en formant une matrice de $a \times b$ premières portions de semi-conducteur, avec $a$ et $b$ nombres entiers tels que $a \geq 1$ et $b \geq 2$, ou régulièrement disposées les unes à côté des autres autour d'un axe central de symétrie.

Le dispositif photodétecteur peut comporter en outre au moins une optique de focalisation et/ou de filtrage disposée en regard des premières, deuxième et troisième portions de semi-conducteur.

L'invention concerne également un capteur d'image comportant une pluralité de pixels, chaque pixel comportant au moins un dispositif photodétecteur selon l'invention.

Le capteur d'image peut comporter en outre des niveaux d'interconnexions électriques disposés entre la couche de semi-conducteur et des optiques de focalisation et/ou de filtrage des dispositifs photodétecteurs. Un tel capteur d'image correspond à un capteur de type « front-side ».

En variante, la couche de semi-conducteur peut être disposée entre des niveaux d'interconnexions électriques et des optiques de focalisation et/ou de filtrage des dispositifs photodétecteurs. Un tel capteur d'image correspond à un capteur de type « back-side ».

Le dispositif photodétecteur selon l'invention peut notamment être utilisé pour différentes applications telles que :

- la réalisation de pixels à hautes performances permettant de corriger, par des calculs postérieurs à la capture d'image, des défauts internes des pixels ou des défauts des optiques couplées aux pixels, par la combinaison des diverses informations fournies par les dispositifs photodétecteurs ;
- une mesure de la direction et de la valeur du gradient de la lumière capturée dans chaque pixel, en plus de l'intensité totale capturée par les pixels, et cela sans microlentille ou autre focale de lentille ;
- la capture de plusieurs couleurs dans un seul pixel ;
- la mesure de distance dans une image capturée, via la réalisation de calculs à partir des différentes informations fournies par les pixels ;
- la réalisation d'un capteur d'image plenoptique ;
- la réalisation d'un dispositif de type Shack-Hartmann ;
- une mesure d'autofocus par contraste de phase, avec ajout de prisme et de diaphragmes couplés aux dispositifs photodétecteurs ;
- la réalisation d'un capteur vidéo haute performance par des lectures variables d'images successives, grâce à des pixels de configuration interne différente d'image en image via différentes utilisations des dispositifs de lecture des informations fournies par les dispositifs photodétecteurs ;
- la réalisation d'images HDR (« High Dynamic Range », ou à grande gamme dynamique) par des lectures à des temps différents de chaque dispositif photodétecteur d'un même pixel.

Les applications des dispositifs photodétecteurs peuvent dépendre du système optique et des réglages choisis pour l'ensemble des dispositifs photodétecteurs.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

- les figures 1, 4 et 5 représentent schématiquement des vues en coupe de capteurs d'image selon l'art antérieur ;
- la figure 2 représente schématiquement une zone photodétectrice d'un capteur d'image selon l'art antérieur ;
- la figure 3 représente le profil de variation de potentiel obtenu dans la zone photodétectrice de la figure 2 ;

- la figure 6 représente schématiquement une vue en coupe d'un pixel d'un capteur d'image, objet de la présente invention, selon un premier mode de réalisation et comprenant un dispositif photodétecteur également selon l'invention ;
- la figure 7 représente schématiquement la zone photodétectrice du dispositif photodétecteur représenté sur la figure 6 ;
- la figure 8 représente les potentiels dans différents plans de la zone photodétectrice représentée sur la figure 7 ;
- la figure 9 représente la variation de potentiel obtenue le long de la zone photodétectrice représentée sur la figure 7 ;
- la figure 10 représente schématiquement une vue de dessus d'un dispositif photodétecteur selon l'art antérieur;
- les figures 11 à 13 représentent schématiquement des vues de dessus de dispositifs photodétecteurs, objets de la présente invention, selon différentes variantes de réalisation ;
- la figure 14 représente schématiquement une zone photodétectrice d'un dispositif photodétecteur, objet de la présente invention, selon une variante de réalisation ;
- la figure 15 représente les potentiels dans différents plans de la zone photodétectrice représentée sur la figure 14 ;
- la figure 16 représente schématiquement une zone photodétectrice d'un dispositif photodétecteur, objet de la présente invention, selon une autre variante de réalisation ;
- la figure 17 représente les potentiels dans différents plans de la zone photodétectrice représentée sur la figure 16 ;
- les figures 18 et 19 représentent schématiquement des vues en coupe d'un pixel d'un capteur d'image, objet de la présente invention, selon un deuxième et un troisième mode de réalisation, et comprenant chacun un dispositif photodétecteur également selon l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

**EXPOSÉ DÉTAILLÉ DE MODES DE RÉALISATION PARTICULIERS**

On se réfère tout d'abord à la figure 6 qui représente schématiquement une vue en coupe d'un pixel d'un capteur d'image 100 selon un premier mode de réalisation. Bien que non représentée, le capteur d'image 100 comporte une matrice de pixels sensiblement similaires au pixel représenté sur la figure 6. Le capteur d'image 100 est ici de type CMOS.

Ce pixel est réalisé à partir d'un dispositif photodétecteur 102 comprenant une zone photodétectrice réalisée dans une couche 104 de semi-conducteur, comportant par exemple du silicium dopé p, de dopage par exemple compris entre environ $1.10^{14}$ atomes/cm$^3$ et $1.10^{16}$ atomes/cm$^3$ et formant une couche active du dispositif photodétecteur 102. Le dispositif photodétecteur 102 comporte, dans ce premier mode de réalisation, deux premières portions 106a et 106b de semi-conducteur dopé n, de dopage par exemple égal à environ $10^{17}$ atomes/cm$^3$, correspondant à deux régions dopées n de la couche 104. Ces deux premières portions 106a, 106b sont séparées d'une interface 109, correspondant à une face supérieure de la couche 104, par une deuxième portion 108 de semi-conducteur dopé p+, correspondant à une région dopée p+ de la couche 104, de dopage par exemple compris entre environ $1.10^{18}$ atomes/cm$^3$ et $1.10^{20}$ atomes/cm$^3$. Chacune des premières portions 106a, 106b de dopage n forme, avec le dopage p de la couche 104 et le dopage p+ de la deuxième portion 108, un ensemble de jonctions p-n du dispositif photodétecteur 102.

Une partie 110 de la couche 104 de semi-conducteur dopé p, est disposée entre les deux premières portions 106a, 106b, permettant ainsi la formation d'une barrière de potentiel entre les deux premières portions 106a, 106b. En variante, le dopage du semi-conducteur de la partie 110 peut être très légèrement de type p-, c'est-à-dire très faiblement inférieur au dopage p initial de la couche 104. La distance (selon l'axe X sur la figure 6) entre les deux premières portions 106a et 106b est par exemple comprise entre environ 0,2 $\mu$m et 1 $\mu$m. Selon l'application envisagée pour le capteur d'images 100, l'épaisseur (dimension selon l'axe Z sur la figure 6) des premières portions 106a, 106b est par exemple comprise entre environ 0,5 $\mu$m et 3 $\mu$m, et la longueur et la largeur (dimensions selon les axes X et Y sur la figure 6) des premières portions 106a, 106b sont par exemple comprises entre environ 0,3 $\mu$m et 10 $\mu$m.

Des niveaux d'interconnexions électriques 112 sont disposés au-dessus de la couche 104, sur la face supérieure de la couche 104. Ces niveaux d'interconnexions électriques 112 comportent notamment des lignes électriques de connexion, des vias conducteurs reliant électriquement les différentes lignes électriques, ainsi que des grilles de transistors MOS. Ces éléments conducteurs sont réalisés dans des couches diélectriques transparentes 114, ici à base de SiO$_2$.

Deux grilles de transfert 116a et 116b, formant deux noeuds de lecture, sont réalisées dans les niveaux d'interconnexions électriques 112 et sont chacune couplées électriquement à l'un des deux ensembles des jonctions p-n. La première grille de transfert 116a est couplée électriquement aux jonctions p-n formées par la première portion 106a de type n avec la couche 104 de type p d'une part, et avec la partie de la deuxième portion 108 de type p+ disposée contre la première portion 106a d'autre part. La deuxième grille de transfert 116b est couplée électriquement aux jonctions p-n formées par la deuxième portion 106b de type n avec la couche 104 de type p d'une part, et avec la partie de la deuxième portion 108 de type p+ disposée contre la deuxième portion 106b d'autre part. Les largeurs des grilles de transfert 116a, 116b (dimension selon l'axe X représenté sur la figure 6) sont par exemple comprises entre environ 0,03 $\mu$m et 1 $\mu$m. Le pixel comporte également des transistors non représentés sur la figure 6, dont le nombre dépend de la structure du pixel, par exemple de type 3T ou 4T.

Le dispositif photodétecteur 102 comporte également une optique disposée en regard de sa zone photodétectrice. Dans ce premier mode de réalisation, cette optique comprend une microlentille 120 apte à focaliser des rayons lumineux reçus sur les jonctions p-n du dispositif photodétecteur 102, et un filtre coloré 122 faisant partie d'une matrice de Bayer. L'optique associée au dispositif photodétecteur 102 peut comporter d'autres éléments et/ou des éléments différents, tels que des prismes ou des réseaux de diffraction. Une région 124 des couches diélectriques transparentes 114 se trouvant en regard de la zone photodétectrice du dispositif photodétecteur 102, entre la zone photodétectrice et l'optique, ne comporte pas d'interconnexions électriques afin que la lumière issue de cette optique puisse arriver dans la zone photodétectrice du dispositif photodétecteur 102 sans réflexion sur les interconnexions électriques. Le capteur d'image 100 est ici de type « front-side », c'est-à-dire comporte les niveaux d'interconnexions électriques 112 disposés entre la couche de semi-conducteur 104 et l'optique de focalisation et de filtrage disposée en regard des jonctions p-n du dispositif photodétecteur 102.

La première grille de transfert 116a permet de transférer les charges photo-générées, séparées par le premier ensemble de jonctions p-n (première portion 106a avec la couche 104 et avec la partie correspondante de la deuxième portion 108) et stockées dans la première portion 106a, vers une autre région 118a de semi-conducteur dopé n de la couche 104, et la deuxième grille de transfert 116b permet de transférer les charges photo-générées, séparées par le deuxième ensemble de jonctions p-n (première portion 106b avec la couche 104 et avec la partie correspondante de la deuxième portion 108) et stockées dans la première portion 106b, vers une autre région 118b de semi-conducteur dopé n de la couche 104. Les deux grilles de transfert 116a et 116b forment donc deux noeuds de lecture du dispositif photodétecteur 102, pouvant fonctionner indépendamment l'un de l'autre ou simultanément, et ainsi extraire deux informations distinctes fournies par un seul pixel (correspondant aux charges électriques photo-générées, séparées par chacun des ensembles de jonctions p-n et stockées dans chacune des premières portions 106). Ces informations distinctes permettent, par exemple via un calcul réalisé à partir de ces deux signaux, d'apporter des améliorations à l'image fournie par les pixels, via l'exploitation numérique de cette pluralité d'informations obtenues à partir de chaque pixel.

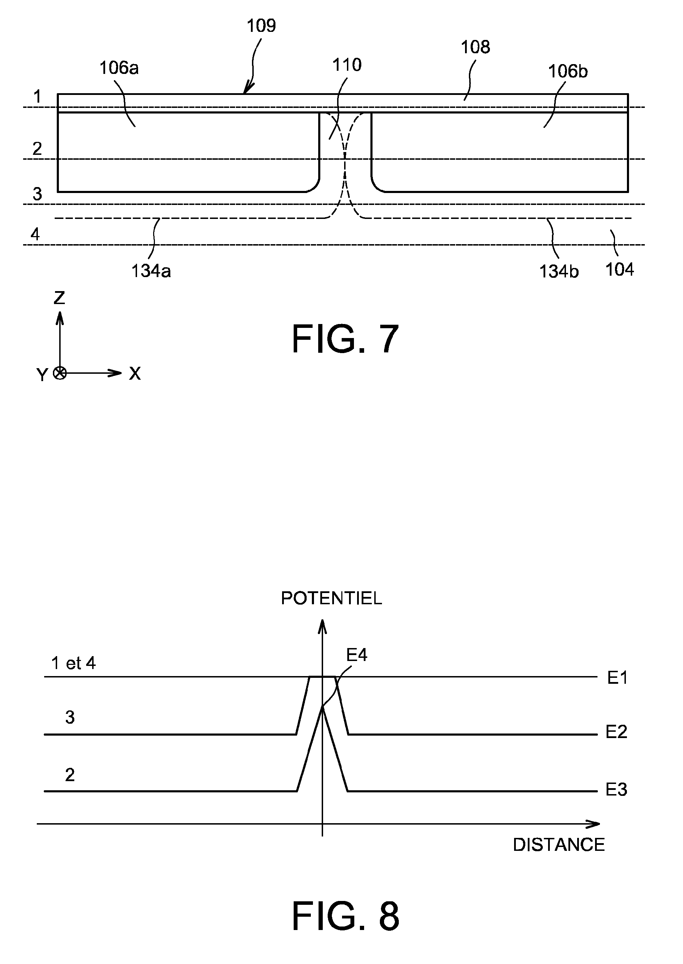

La figure 7 représente la zone photodétectrice du dispositif photodétecteur 102 de la figure 6. Les pointillés 134a et 134b délimitent symboliquement les zones de charge d'espace obtenues autour de chacune des premières portions 106a, 106b. Les deux premières portions 106a et 106b sont ici réalisées assez proches l'une de l'autre pour que les bords de ces zones se chevauchent et forment ainsi une barrière de potentiel franchissable par les charges électriques.

La figure 8 représente les variations de potentiel obtenues dans la zone photodétectrice de la figure 7 aux niveaux de différents plans de cette zone numérotés 1 à 4. Au niveau des plans 1 et 4 qui se trouvent respectivement au niveau de la deuxième portion 108 dopée p+ et de la couche 104 dopée p, en dehors des zones 134a et 134b, le potentiel électrique est constant et égal à une première valeur haute $E_1$. Au niveau du plan 3 se trouvant au niveau de la couche 104 mais passant dans les zones 134a et 134b, le potentiel est, dans les zones 134a et 134b, à une deuxième valeur $E_2$ inférieure à la première valeur de potentiel $E_1$. Entre les zones 134a et 134b, c'est-à-dire dans la partie 110 de la couche 104, le niveau du potentiel atteint la première valeur haute $E_1$. On a donc, dans ce plan, une séparation totale entre les deux zones 134a et 134b, c'est-à-dire non franchissable par des charges électriques. Dans le plan 2, le potentiel dans les premières portions 106a et 106b a une troisième valeur $E_3$ inférieure à la deuxième valeur $E_2$. Entre les premières portions 106a et 106b, c'est-à-dire dans la partie 110 dans laquelle les zones 134a et 134b se rejoignent, la valeur du potentiel varie jusqu'à atteindre un pic de valeur $E_4$ inférieure à la première valeur $E_1$, et revient ensuite à la troisième valeur, formant ainsi une barrière de potentiel franchissable par les charges électriques.

Ainsi, lorsque des charges s'accumulent d'un côté de cette barrière dans un des puits de potentiel, elles sont stockées tant que leur nombre n'est pas suffisant pour franchir la barrière de potentiel. Par contre, lorsque le nombre de charges est tel que le niveau de la barrière est dépassé, les charges supplémentaires arrivant de ce côté se déversent alors de l'autre côté de la barrière de potentiel dans l'autre puits de potentiel.

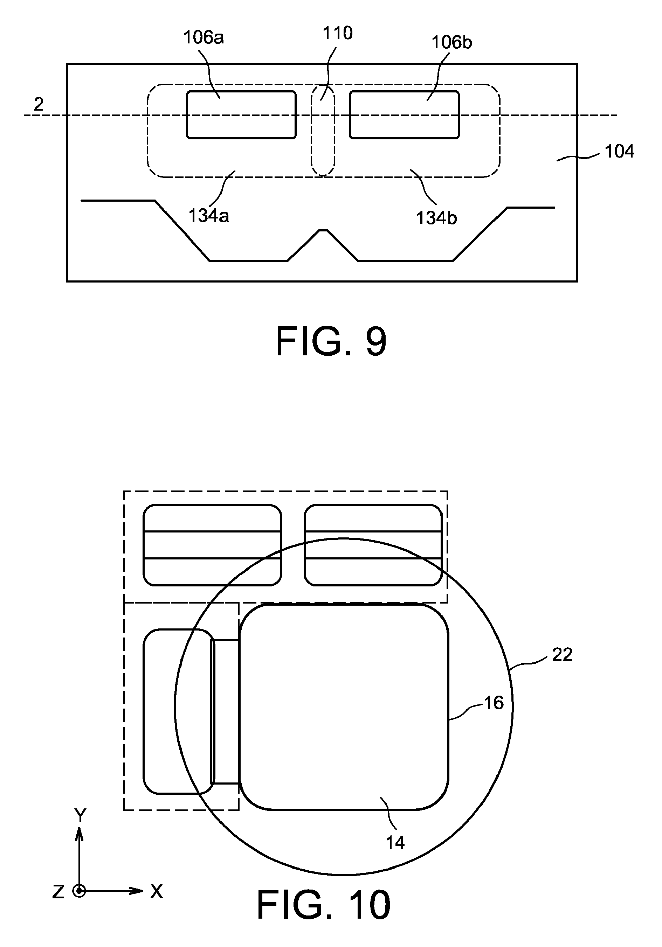

La figure 9 représente la variation de potentiel obtenue le long du plan 2. On voit notamment sur cette figure que la barrière de potentiel formée au niveau de la partie 110 a un niveau inférieur aux potentiels dans les zones extérieures de la couche 104, en dehors des zones 134a et 134b. Ainsi, les charges ont tendance à franchir cette barrière de potentiel lorsque celles-ci dépassent le niveau de cette barrière tout en restant dans les puits de potentiel ainsi formés.

Chacune des premières portions 106a, 106b forme une capacité de stockage électrique. Les charges photo-générées sont stockées dans cette capacité durant le temps d'intégration de l'image (correspondant au temps de pose du capteur 100). Du fait que les zones de charge d'espace autour des deux premières portions 106a, 106b se chevauchent au niveau de la partie 110, si le puits de potentiel formé par l'une de ces deux premières portions 106a, 106b approche de la saturation de charges, alors les charges vont passer la barrière de potentiel formée au niveau la partie 110 et se déverser dans l'autre puits de potentiel formé par l'autre des deux premières portions 106a, 106b. Ces deux sous-zones photodétectrices formées dans ce pixel peuvent stocker au total quasiment autant de charges qu'une unique zone photodétectrice classique d'un pixel de dimensions sensiblement similaires. Par une simple somme des deux signaux récupérés, il est donc possible de remonter au signal donné par un pixel classique, c'est-à-dire sans prendre en compte l'information liée à la répartition des charges dans l'une ou l'autre des parties de la jonction p-n. Du fait du débordement des charges d'une région à l'autre, une même dynamique entre le niveau du bruit et la saturation est conservée par rapport à un pixel de taille équivalente mais comportant une jonction p-n classique telle que celle représentée sur la figure 1. Un traitement et un multiplexage des signaux délivrés par les pixels du capteur 100 peuvent ensuite être réalisés.

Les deux grilles de transfert 116a, 116b peuvent être commandées par un même signal de commande appliqué sur ces deux grilles, et ainsi travailler à la même cadence et simultanément. Les deux noeuds de lecture ainsi formés peuvent fonctionner de manière synchrone. A la place des grilles de transfert 116a, 116b, il est possible de faire appel à d'autres dispositifs de lecture tels que des transistors.

Il est toutefois possible d'exploiter différemment ces deux informations fournies par le dispositif photodétecteur 102. L'information supplémentaire liée à la différence des charges générées entre les deux premières portions 106a et 106b est bien une information d'intensité, mais ne concerne pas directement l'intensité de l'image capturée. Cette information supplémentaire peut être utilisée pour en déduire des informations liées à la mise au point ou encore à la profondeur de champ de l'image capturée par le capteur d'image 100.

Cette information supplémentaire peut également être utilisée pour corriger un défaut optique du capteur 100 ou bien choisir un système optique plus facile à réaliser. Cette information supplémentaire fournie par chaque pixel permet également d'apporter de multiples améliorations à l'image, par ajustement du système optique et/ou traitement de l'information (par exemple via des interpolations permettant d'augmenter la résolution de l'image).

Dans l'exemple de la figure 6, les grilles de transfert 116a, 116b permettent de transférer les signaux lus, c'est-à-dire les charges photo-générées, séparées par les jonctions p-n et stockées dans les premières portions 106, à des amplificateurs, non représentés sur la figure 6. En variante, il est possible que les deux parties de la jonction p-n soient directement couplées à des transistors amplificateurs réalisés dans ce cas à la place des grilles de transfert 116a, 116b. En variante, et notamment dans le cas de petites zones photodétectrices (par exemple d'1 μm ou moins), il est possible d'utiliser certaines des grilles de transfert du dispositif photodétecteur de manière différente, c'est-à-dire qu'une partie d'entre elles seront utilisées pour transférer les charges vers une partie des amplificateurs, et utiliser la partie restante en inverse pour repousser les charges et leur faire franchir la ou les barrières de potentiel entre les jonctions p-n. Ainsi, il est possible de regrouper plus de charges sur quelques ou même un seul transistor amplificateur, et donc d'obtenir un meilleur rapport signal à bruit pour le pixel. On peut ainsi obtenir une image plus lisible vis-à-vis du bruit à basse lumière, mais moins résolue, ou une image bien résolue, mais éventuellement parasité par un bruit.

Dans une variante de réalisation, les dopages des différentes portions de semi-conducteur peuvent être de type inverse à ceux précédemment décrits. Ainsi, il est possible que la couche 104 et la partie 110 comportent du semi-conducteur dopé n, que les premières portions 106a, 106b comportent du semi-conducteur dopé p, et que la deuxième portion 108 comporte du semi-conducteur dopé n+.

De plus, dans l'exemple précédemment décrit en liaison avec la figure 6, la zone photodétectrice du pixel comporte deux premières portions 106a, 106b de semi-conducteur dopé n séparées de l'interface 109 par une deuxième portion 108 de semi-conducteur dopé p+, et formant, avec la deuxième portion 108 et la couche 104, deux ensembles de jonctions p-n. Le recouvrement des zones de charge d'espace des jonctions associées aux premières portions 106a, 106b forme une barrière de potentiel séparant les puits de potentiel formés par les premières portions 106a, 106b.. En variante, la zone photodétectrice peut comporter un nombre plus important de premières portions 106 de semi-conducteur dopé n séparées de l'interface 109 par une ou plusieurs deuxièmes portions 108 de semi-conducteur dopé p+ (ou de premières portions 106 de semi-conducteur dopé p séparées de l'interface 109 par à une ou plusieurs deuxièmes portions 108 de semi-conducteur dopé n+). On forme ainsi plus de deux ensembles de jonctions p-n dont les premières portions 106 forment des puits de potentiel séparés les uns des autres par des barrières de potentiels obtenues par le recouvrement des zones de charges d'espace de ces ensembles de jonctions p-n.

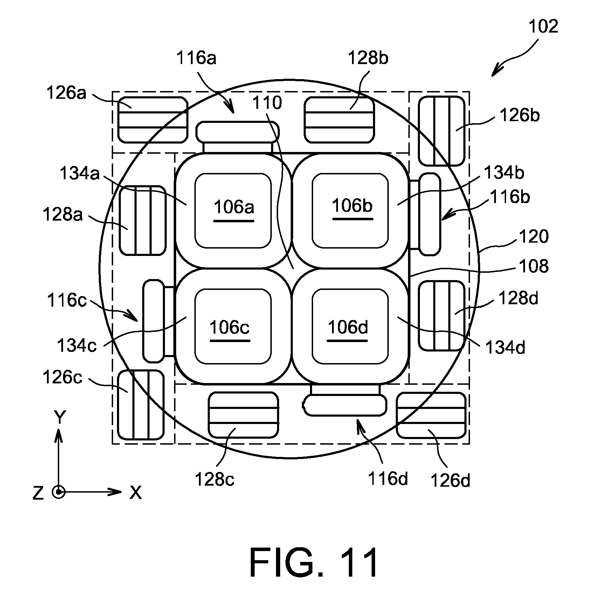

La figure 11 représente schématiquement une vue de dessus d'un dispositif photodétecteur 102 dont la zone photodétectrice est divisée en quatre parties, ou quatre sous-zones photodétectrices, et comporte quatre premières portions 106a, 106b, 106c et 106d dopées n formées dans la couche 104, disposées en matrice 2 x 2 et chacune de section (dans le plan (X,Y) parallèle à la face 109 de la couche 104) de forme sensiblement rectangulaire. Ces quatre premières portions 106a - 106d sont séparées de l'interface 109 par une deuxième portion 108 de semi-conducteur dopé p+ en contact avec ces quatre premières portions 106a - 106d et de section dans le plan (X,Y) de forme sensiblement rectangulaire. Les quatre premières portions 106a-106d sont espacées les unes des autres par des parties 110 de la couche 104 dopée p. Chacune des zones de charge d'espace 134a-134d autour de chacune de ces quatre premières portions 106a - 106d chevauche les zones de charge d'espace des deux premières portions 106a - 106d dopées n qui lui sont adjacentes, formant ainsi des barrières de potentiel entre chacune des premières portions 106a - 106d. Quatre noeuds de lecture 116a - 116d, formés ici par des grilles de transfert, sont couplés à chacun des quatre ensembles de jonctions p-n ainsi formés. Enfin, chacun des quatre ensembles de jonctions p-n est également couplé à des transistors schématisés par deux transistors, référencés 126a - 126d et 128a - 128d. A titre de comparaison, un pixel de dimensions (notamment dans le plan (X,Y)) similaires à celui représenté sur la figure 11, mais comportant une jonction p-n classique, c'est-à-dire non formée par plusieurs régions séparées entre elles par des barrières de potentiel, est représenté sur la figure 10.

Avec ces quatre sous-zones photodétectrices couplées à une optique principale comportant 4 filtres répartis comme dans un motif de base d'une matrice de Bayer, il est possible de remonter aux coordonnées décrivant la couleur dans chaque sous-pixel par une combinaison linéaire adaptée aux couleurs des filtres. Selon un autre exemple de réalisation, sans filtre dans l'optique principale, en considérant les quatre signaux a, b, c et d délivrés par ces quatre sous-zones photodétectrices, il est par exemple possible de calculer le module du gradient de variation entre ces sous-zones par l'équation

$$\sqrt{(a-d)^2+(b-c)^2}.$$

L'angle de direction du gradient peut également être calculé selon l'équation ($a$-$d$)/($b$-$c$). Enfin, le contraste directionnel peut être calculé                               par                               l'équation

$$\sqrt{(a-d)^2+(b-c)^2}\Big/(a+b+c+d).$$

D'autres modifications du système optique se trouvant devant les pixels peuvent permettre d'extraire d'autres informations par la mise en oeuvre d'autres calculs.

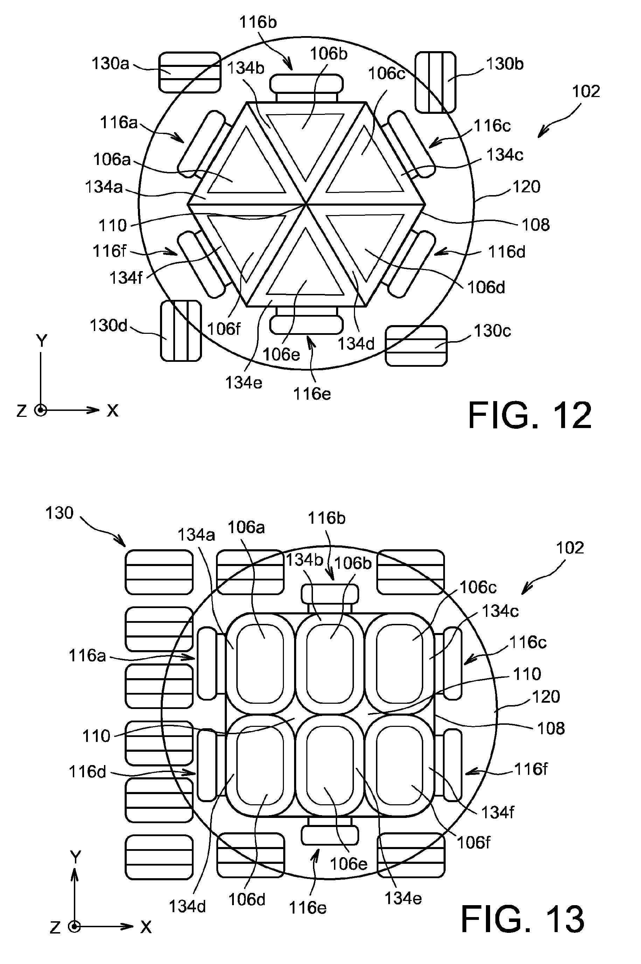

Chaque pixel peut comporter un nombre de premières portions de semi-conducteur différent de ceux précédemment décrits, et/ou des premières portions de semi-conducteur disposées différemment et/ou de forme différente. La figure 12 représente un autre exemple de réalisation du dispositif photodétecteur 102 comportant ici six premières portions 106a à 106f de semi-conducteur dopé n chacune de forme sensiblement triangulaire, séparées de l'interface 109 par une deuxième portion 108 dopée p+ de forme sensiblement hexagonale. Des zones de charge d'espace 134a - 134f autour de ces premières portions 106a - 106f sont également de forme sensiblement triangulaire et se chevauchent les unes avec les autres au niveau de parties 110 de semi-conducteur dopé p se trouvant entres les premières portions 106a - 106f, formant des barrières de potentiels entre les puits de potentiel formés par les premières portions 106a - 106f. Chacune des premières portions 106a - 106f est couplée à un noeud de lecture 116a - 116f permettant de réaliser un transfert des charges photo-générées dans la partie de la jonction p-n correspondante. Quatre autres transistors 130a - 130d servant au traitement des signaux lus sont représentés sur la figure 12.

Un autre exemple de réalisation du dispositif photodétecteur 102 est représenté sur la figure 13. La zone photodétectrice du dispositif photodétecteur 102 comporte ici six premières portions 106a - 106f de semi-conducteur dopé n chacune de forme sensiblement rectangulaire. Les zones de charge d'espace 134a - 134f autour de chacune de ces premières portions 106a - 106f est en contact avec deux ou trois autres zones de charge d'espace formées autour des premières portions 106a - 106f voisines, formant des barrières de potentiel dans les parties dopées n 110 de la couche de semi-conducteur 104 se trouvant entre les premières portions 106a - 106f, séparant les puits de potentiel formés par ces premières portions 106a - 106f. La deuxième portion 108 dopée p+ en contact avec les premières portions 106a - 106f est de forme sensiblement rectangulaire et sépare l'interface 109 des premières portions 106a - 106f. Chacune des premières portions 106a - 106f est couplée à un noeud de lecture 116a - 116f permettant de réaliser un transfert des charges générées dans la partie de la jonction p-n correspondante. D'autres transistors 130 servant au traitement des signaux lus sont représentés sur la figure 13.

Dans tous les exemples de réalisation précédemment décrits, il est possible d'abaisser la ou les barrières de potentiels formées entres les premières portions 106 en réalisant, dans la ou les parties 110, des régions dopées n-.

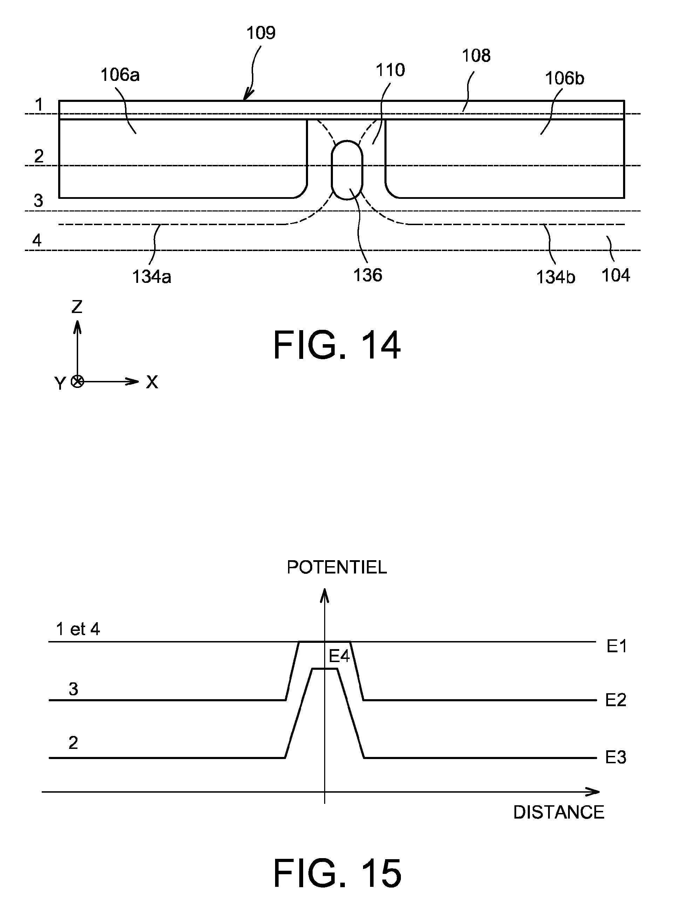

La figure 14 représente schématiquement une zone photodétectrice comportant deux sous-zones photodétectrices réalisées par deux premières portions 106a et 106b de semi-conducteur dopé n réalisée dans la couche 104 dopée p et séparées de l'interface 109 par une deuxième portion 108 dopée p+. Une quatrième portion 136 de semi-conducteur dopée n- est formée dans la partie 110 se trouvant entre les deux premières portions 106a et 106b.

La figure 15 représente les variations de potentiel obtenues dans la zone photodétectrice de la figure 14 aux niveaux de différents plans numérotés 1 à 4. Par rapport aux variations de potentiel précédemment décrites en liaison avec la figure 8, les deux premières portions 106a et 106b sont plus espacées l'une de l'autre, ce qui augmente, dans le plan 3, la largeur du plateau à la première valeur haute $E_1$ (qui correspond à la valeur du potentiel dans les plans 1 et 4). De plus, contrairement au cas précédemment décrit en liaison avec la figure 8, les zones de charge d'espace 134a et 134b ne se chevauchent pas l'une avec l'autre. Toutefois, grâce à la quatrième portion 136 dopée n- qui se trouve entre ces zones, une barrière de potentiel est bien obtenue en raison de la valeur $E_4$ du potentiel dans cette portion 136 qui est inférieure à la valeur $E_1$ des potentiels dans les régions p et p+.

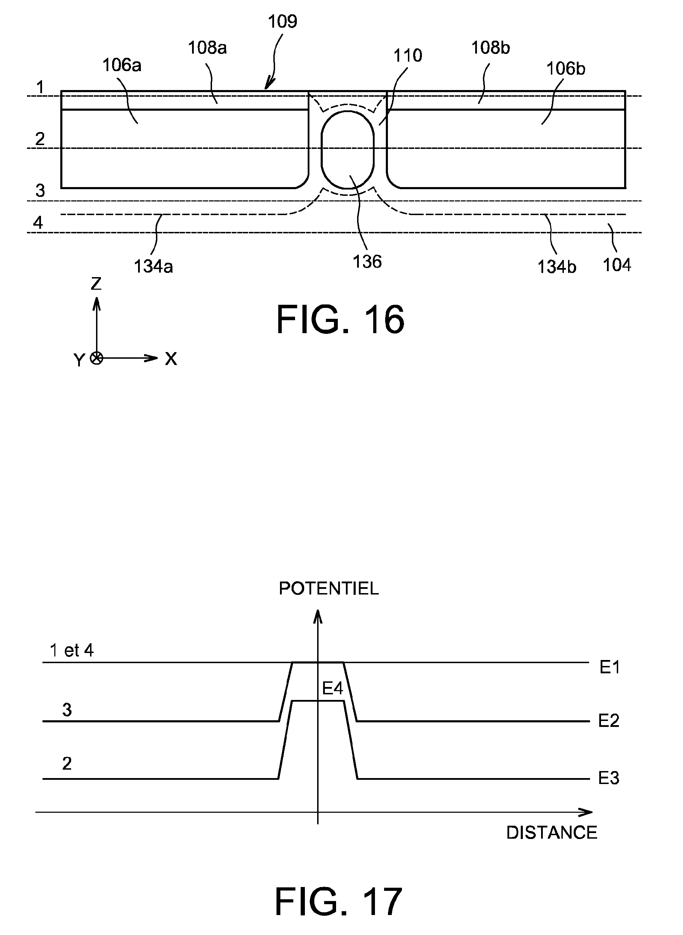

La figure 16 représente schématiquement une zone photodétectrice comportant deux sous-zones photodétectrices réalisées par deux premières portions 106a et 106b de semi-conducteur dopé n réalisée dans la couche 104 dopée p et séparées de l'interface 109 par une deuxième portion 108a et 108b dopée p+ distincte. Une quatrième portion 136 de semi-conducteur dopée n- est formée dans la partie 110 se trouvant entre les deux premières portions 106a et 106b. Cette quatrième portion 136 est plus large que celle se trouvant dans la zone photodétectrice précédemment décrite en liaison avec la figure 14, ce qui se traduit par l'obtention d'une barrière de potentiel plus large, et donc plus facilement réalisable, comme représenté sur la figure 17.

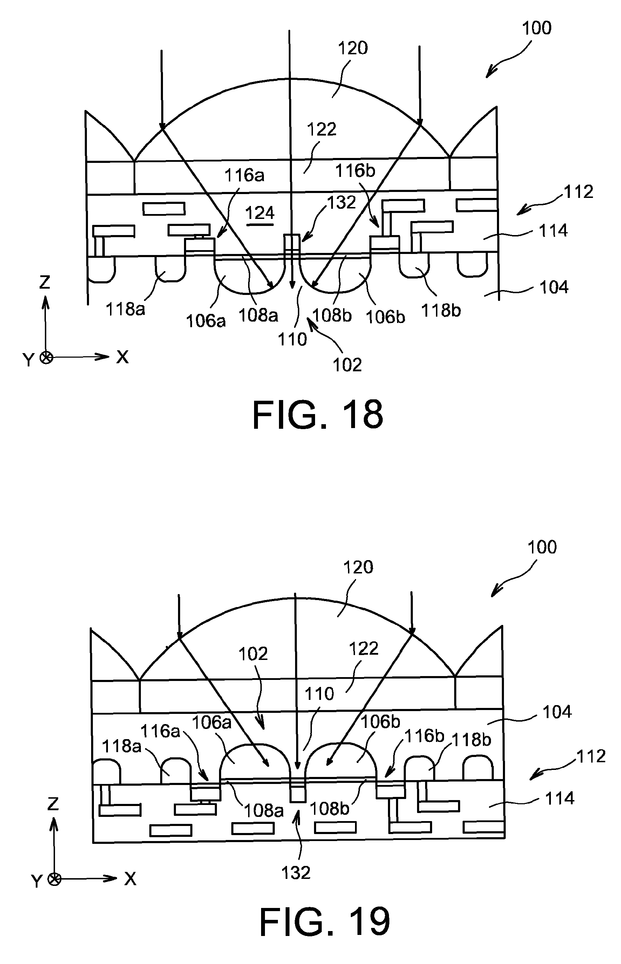

La figure 18 représente schématiquement une vue en coupe d'un pixel du capteur d'image 100 selon un deuxième mode de réalisation.

Contrairement au capteur d'image 100 précédemment décrit en liaison avec la figure 6, les premières portions 106a et 106b de semi-conducteur dopé n sont espacées l'une de l'autre telles que les zones de charge d'espace formées autour de ces premières portions 106a et 106b ne se chevauchent pas. De plus, chacune des premières portions 106a et 106b est séparée de l'interface 109 par une deuxième portion 108a et 108b de semi-conducteur dopée p+ distincte. Afin que la barrière de potentiel formée par la partie 110 puisse être franchie par les charges se trouvant dans l'un des puits de potentiel formés par les premières portions 106a, 106b et circuler entre ces puits de potentiel, une grille de commande 132 est disposée sur la partie 110. Cette grille de commande permet de contrôler le niveau de cette barrière de potentiel par des effets de champ électrique obtenus en appliquant une tension sur cette grille de commande 132. Cette grille de commande 132 est de structure similaire à celle de la grille d'un transistor MOS (comportant une portion conductrice disposée sur une couche mince diélectrique appelée diélectrique de grille).

Lorsqu'aucune tension n'est appliquée sur la grille de commande 132, les charges ne peuvent pas passer d'une des premières portions 106a et 106b à l'autre car le potentiel est égal, dans la partie 110, à la première valeur haute $E_1$ correspondant au potentiel dans les régions p et p+. Par contre, quand la tension appliquée sur la grille de commande 132 forme un canal dans la partie 110 entre les premières portions 106a et 106b, cela abaisse le potentiel et forme alors une barrière de potentiel franchissable par les charges électriques et dont le niveau peut être ajusté en fonction de la tension appliquée sur la grille de commande 132. Ainsi, il est possible de contrôler par exemple le débordement des charges d'une des premières portions 106a et 106b à l'autre. En appliquant une tension suffisamment forte sur la grille de commande 132, il est possible de supprimer complètement la barrière de potentiel entre les premières portions 106a et 106b, la zone photodétectrice formant alors un unique puits de potentiel équivalent à un unique pixel.

La grille de commande 132 est réalisée de préférence transparente à la lumière, la portion conductrice de cette grille pouvant par exemple être réalisée à base d'ITO (oxyde d'indium et d'étain), afin que la lumière capturée dans le pixel puisse atteindre la zone photodétectrice du pixel sans être reflétée par la grille de commande 132.

Ce deuxième mode de réalisation peut s'appliquer à l'ensemble des dispositifs photodétecteurs précédemment décrits, chaque barrière de potentiel étant associée à une grille de commande, les différentes grilles de commande pouvant être contrôlées indépendamment ou non les unes des autres. Il est également possible d'avoir un dispositif photodétecteur comportant une ou plusieurs barrières de potentiel similaires à celle précédemment décrite en liaison avec la figure 6 et une ou plusieurs barrières de potentiel similaires à celle décrite dans ce deuxième mode de réalisation (c'est-à-dire commandées par des grilles de commande).

La figure 19 représente schématiquement une vue en coupe d'un pixel du capteur d'image 100 selon un troisième mode de réalisation.

Contrairement aux capteurs d'image 100 précédemment décrits en liaison avec les figures 6 et 18, le capteur d'image 100 est ici de type « back-side », la couche semi-conductrice 104 se trouvant entre les optiques et les niveaux d'interconnexions électriques 112. Comme dans le capteur d'image 100 précédemment décrit en liaison avec la figure 18, les premières portions 106a et 106b de semi-conducteur dopé n sont séparées par une partie 110 de la couche 104 de semi-conducteur dopé p permettant d'établissement d'une barrière de potentiel commandée par la grille de commande 132. Du fait que la grille de commande 132 est réalisée dans les niveaux d'interconnexions 112 qui ne sont ici pas destinés à être traversés par la lumière reçue par le pixel, cette grille de commande 132 peut être réalisée indifféremment à partir de matériaux transparents ou non, et avantageusement réalisées à partir des mêmes matériaux que ceux utilisés pour réaliser les grilles des autres transistors MOS du capteur d'image 100. De plus, par rapport à un capteur d'image front-side, un tel capteur d'image back-side peut comporter un plus grand nombre d'interconnexions électriques du fait qu'il n'est pas nécessaire de conserver, en regard des zones photodétectrices, des régions dépourvues d'éléments d'interconnexions telles que les régions 124 précédemment décrites.

Le capteur d'image 100 précédemment décrit en liaison avec la figure 6 peut également être réalisé tel qu'il soit de type « back-side ».

Dans tous les exemples de réalisation du dispositif photodétecteur 102 précédemment décrits, les différentes parties des jonctions p-n du dispositif photodétecteur 102 sont disposées les unes à côté des autres en respectant une répartition symétrique dans le dispositif (symétrie axiale dans le plan (X,Y) dans les exemples des figures 6, 11 et 13, et symétrie centrale dans l'exemple de la figure 12), notamment vis-à-vis de l'optique du pixel (microlentille 120 et filtre 122 dans les exemples). Le nombre, la forme et la disposition des différentes parties des jonctions p-n, c'est-à-dire des premières parties de semi-conducteur 106, sont des paramètres choisis en fonction du type d'information supplémentaire souhaitée. Ainsi, les exemples de réalisation précédemment décrits en liaison avec les figures 11 et 13 permettent d'obtenir une information directionnelle, c'est-à-dire permettent d'avoir plus d'information selon une première direction (3 photodétecteurs) que selon les autres directions (2 photodétecteurs). L'exemple précédemment décrit en liaison avec la figure 12 permet d'obtenir une information d'isotropie, et ainsi vérifier la variation selon 3 directions dans le plan du détecteur et les écarts entre ses directions.

Lorsque les jonctions p-n sont formées de plus de deux parties, les grilles de commande permettant de contrôler les barrières de potentiel peuvent fonctionner indépendamment les unes des autres et par leur pilotage, permettre un transfert des charges plus versatile et plus variable dans le temps. Par exemple, il est possible de réaliser un transfert de toutes les charges vers une même première portion 106 afin que les charges soient traitées par un même amplificateur, ou que les charges se trouvant dans les différentes premières portions 106 soient successivement transférées vers un même amplificateur. Cela peut être mis en oeuvre d'image en image dans le temps pour évaluer et corriger des disparités entre les différents éléments du pixel.

Dans tous les modes de réalisation et exemples de réalisation précédemment décrits, les transistors peuvent être mutualisés entre des pixels adjacents du capteur d'image 100. Par exemple, les transistors 126, 128 et 130 précédemment décrits en liaison avec les figures 11 à 13 peuvent être communs aux pixels adjacents au pixel décrit sur ces figures. Les pixels peuvent être lus un par un (ou ligne par ligne) et les schémas connus de mutualisation des transistors utilisés successivement entre pixels peuvent fonctionner entre les nouveaux pixels voisins.

Dans tous les modes de réalisation et exemples de réalisation précédemment décrits, les transistors MOS et grilles (commande, transfert, etc.) peuvent être réalisés avec une longueur de grille comprise entre environ 0,1 $\mu$m et 1 $\mu$m.

Toutes les parties des jonctions p-n ne sont pas nécessairement utilisées à toutes les lectures des pixels.

La réalisation des dispositifs photodétecteurs précédemment décrits est obtenue par la mise en oeuvre d'étapes du domaine de la microélectronique : masquage, implantation de dopants, photolithographie, gravure, etc.

Des éléments supplémentaires permettant d'éviter tout débordement des charges entre les différents pixels du capteur d'image (élément anti-éblouissement, ou anti-blooming) peuvent être réalisés entre les pixels du capteur d'image. Un tel effet anti-éblouissement peut consister à polariser les grilles de lecture de manière à créer un très léger canal au-dessus de la ou des barrières de potentiel entre les zones photodétectrices, tout en maintenant l'autre côté de la grille à un potentiel constant.

**Revendications**

1. Dispositif photodétecteur (102) comprenant au moins :

   - une couche de semi-conducteur (104) dopé selon un premier type de conductivité ;
   - deux premières portions (106a - 106f) de semi-conducteur dopé selon un deuxième type de conductivité opposé au premier type de conductivité, distinctes et espacées l'une de l'autre, et disposées dans la couche de semi-conducteur (104) l'une à côté de l'autre ;
   - une deuxième portion (108, 108a, 108b) de semi-conducteur dopé selon le premier type de conductivité avec un niveau de dopage supérieur à celui de la couche de semi-conducteur (104) et délimitant, avec la couche de semi-conducteur (104), les premières portions (106a - 106f) telles que les premières portions (106a - 106f) forment, avec la couche de semi-conducteur (104) et la deuxième portion (108, 108a, 108b), des jonctions p-n,
   dans lequel au moins une partie (110) de la couche de semi-conducteur (104) dopé selon le premier type de conductivité sépare les premières portions (106a - 106f) de manière à ce que des zones de charge d'espace (134a - 134f) entre les premières portions (106a - 106f) forment au moins une barrière de potentiel dont le niveau (E4) est inférieur au niveau de potentiel (E1) de la deuxième portion (108, 108a, 108b) et de la couche de semi-conducteur (104),
   et dans lequel :
   - au moins une quatrième portion (136) de semi-conducteur dopé selon le deuxième type de conductivité est disposée dans la partie (110) de la couche de semi-conducteur (104) entre les premières portions (106a - 106f) de semi-conducteur, et dans lequel un niveau de dopage des premières portions (106a - 106f) de semi-conducteur est supérieur à un niveau de dopage de la quatrième portion (136) de semi-conducteur tel que le niveau de potentiel (E4) de la quatrième portion (136) de semi-conducteur soit inférieur au niveau de potentiel (E1) de la deuxième portion (108, 108a, 108b) et de la couche de semi-conducteur (104), ou
- le dispositif photodétecteur (102) comporte en outre au moins une grille de commande (132) couplée à la partie (110) de la couche de semi-conducteur (104) et apte à commander une valeur du potentiel entre les premières portions (106a - 106f) de semi-conducteur.

2. Dispositif photodétecteur (102) selon la revendication 1, dans lequel la deuxième portion (108, 108a, 108b) de semi-conducteur est disposée dans la couche de semi-conducteur (104).

3. Dispositif photodétecteur (102) selon l'une des revendications précédentes, comportant en outre au moins autant de dispositifs de lecture (116a - 116f) distincts que de premières portions de semi-conducteur, chacun des dispositifs de lecture (116a - 116f) étant couplé à une des premières portions (106a - 106f) de semi-conducteur et apte à réaliser un transfert de charges électriques stockées dans ladite une des premières portions (106a - 106f) de semi-conducteur vers une autre région de semi-conducteur (118a, 118b).

4. Dispositif photodétecteur (102) selon la revendication 3, dans lequel chaque dispositif de lecture (116a - 116f) comporte au moins une grille de transfert couplée à ladite une des premières portions (106a -106f) de semi-conducteur.

5. Dispositif photodétecteur (102) selon l'une des revendications précédentes, dans lequel une largeur de la partie (110) de la couche de semi-conducteur (104) séparant les premières portions (106a - 106f) de semi-conducteur est telle que les zones de charges d'espace (134a - 134f) entre les premières portions (106a - 106f) de semi-conducteur se chevauchent.

6. Dispositif photodétecteur (102) selon l'une des revendications précédentes, dans lequel une largeur de la partie (110) de la couche de semi-conducteur (104) séparant les premières portions (106a - 106f) de semi-conducteur est telle que les zones de charges d'espace (134a - 134f) entre les premières portions (106a - 106f) ne se chevauchent pas.

7. Dispositif photodétecteur (102) selon l'une des revendications précédentes, comportant plusieurs deuxièmes portions (108, 108a, 108b) de semi-conducteur chacune délimitant, avec la couche de semi-conducteur (104), l'une des premières portions (106a - 106f) de semi-conducteur.

8. Dispositif photodétecteur (102) selon l'une des revendications précédentes, comportant une pluralité de premières portions (106a - 106f) de semi-conducteur disposées les unes à côté des autres dans la couche de semi-conducteur (104) en formant une matrice de a $\times$ b premières portions (106a - 106f) de semi-conducteur, avec a et b nombres entiers tels que a $\geq$ 1 et b $\geq$ 2, ou régulièrement disposées les unes à côté des autres autour d'un axe central de symétrie.

9. Dispositif photodétecteur (102) selon l'une des revendications précédentes, comportant en outre au moins une optique de focalisation (120) et/ou de filtrage (122) disposée en regard des premières (106a - 106f), deuxième (108, 108a, 108b) et troisième (110) portions de semi-conducteur.

10. Capteur d'image (100) comportant une pluralité de pixels, chaque pixel comportant au moins un dispositif photodétecteur (102) selon l'une des revendications précédentes.

11. Capteur d'image (100) selon la revendication 10, comportant en outre des niveaux d'interconnexions électriques (112) disposés entre la couche de semi-conducteur (104) et des optiques de focalisation (120) et/ou de filtrage (122) des dispositifs photodétecteurs (102).

12. Capteur d'image (100) selon la revendication 10, dans lequel la couche de semi-conducteur (104) est disposée entre des niveaux d'interconnexions électriques (112) et des optiques de focalisation (120) et/ou de filtrage (122) des dispositifs photodétecteurs (102).

FIG. 1

FIG. 2

POTENTIEL

E1

E2

DISTANCE

# FIG. 3

30

22

α

24

20

26

28

18

16

14

15

12

Z

Y ⊗ → X

# FIG. 4

FIG. 5

FIG. 6

FIG. 7

FIG. 8

FIG. 9

FIG. 10

FIG. 11

FIG. 12

FIG. 13

**FIG. 14**

**FIG. 15**

FIG. 16

FIG. 17

## FIG. 18

## FIG. 19

Europäisches
Patentamt

European
Patent Office

Office européen
des brevets

**RAPPORT DE RECHERCHE EUROPEENNE**

Numéro de la demande

EP 14 18 3209

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | EP 2 618 377 A2 (CANON KK [JP]) 24 juillet 2013 (2013-07-24) * alinéas [0045] - [0054]; figures 1-8 * ----- | 1-12 | INV. H01L27/146 |
| A | US 2002/121652 A1 (YAMASAKI RYO [JP]) 5 septembre 2002 (2002-09-05) * alinéas [0094] - [0100], [0113] - [0119]; figures 2-9 * * alinéa [0118] - alinéa [0119] * * alinéa [0114] - alinéa [0118] * * alinéa [0095] - alinéa [0100] * ----- | 1-12 | |

DOMAINES TECHNIQUES
RECHERCHES (IPC)

H01L

Le présent rapport a été établi pour toutes les revendications

| Lieu de la recherche | Date d'achèvement de la recherche | Examinateur |
|---|---|---|
| La Haye | 26 janvier 2015 | Cabrita, Ana |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 14 18 3209

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-01-2015

| Document brevet cité au rapport de recherche | Date de publication | Membre(s) de la famille de brevet(s) | Date de publication |
|---|---|---|---|
| EP 2618377 A2 | 24-07-2013 | CN 103219347 A<br>EP 2618377 A2<br>JP 2013149743 A<br>RU 2013102275 A<br>US 2013182158 A1 | 24-07-2013<br>24-07-2013<br>01-08-2013<br>27-07-2014<br>18-07-2013 |
| US 2002121652 A1 | 05-09-2002 | JP 4500434 B2<br>JP 2002165126 A<br>US 2002121652 A1 | 14-07-2010<br>07-06-2002<br>05-09-2002 |

EPO FORM P0460

Pour tout renseignement concernant cette annexe : voir Journal Officiel de l'Office européen des brevets, No.12/82